# EUROPEAN PATENT APPLICATION

(11) **EP 4 804 351 A2**
(43) Date of publication of application: **09.09.2026**
(21) Application number: 26160073.8
(22) Date of filing: 23.02.2026
(51) Int. Cl.: H01S 5/30, H01S 5/06, H01S 5/183

(54) **LIGHT EMITTING ELEMENT AND DISTANCE MEASURING APPARATUS**

(30) Priority: 05.03.2025 JP 2025034593; 05.12.2025 JP 2025235871
(71) Applicant: Canon Kabushiki Kaisha, Tokyo 146-8501 (JP)
(72) Inventor: SUGA, Takako, Tokyo, 146-8501 (JP); UCHIDA, Takeshi, Tokyo, 146-8501 (JP); UCHIDA, Tatsuro, Tokyo, 146-8501 (JP)
(74) Representative: Canon Europe Limited

(57) **Abstract**

A light emitting element includes a first reflection mirror provided on a semiconductor substrate, a second reflection mirror provided on the first reflection mirror, a resonator provided between the first reflection mirror and the second reflection mirror, an active layer included in the resonator and including a quantum well layer and a barrier layer, a doped layer provided on at least one of a side of the active layer facing the semiconductor substrate and a side opposite to the semiconductor substrate, a spacer layer provided between the doped layer and the barrier layer and having a band gap larger than a band gap of the barrier layer, and a saturable absorption layer provided between the semiconductor substrate and the second reflection mirror, wherein a doping concentration of the spacer layer is lower than a doping concentration of the doped layer.

## Description

### Technical Field

The present disclosure relates to a light emitting element and a distance measuring apparatus.

### BACKGROUND

Using a vertical cavity surface emitting LASER (VCSEL) as a light source for a light detection and ranging (LiDAR) of a time of flight (ToF) method is known. The VCSEL has an advantage of having little wavelength dependency on temperature.

Japanese Patent Laid-open Publication No. 2022-176886 describes a VCSEL that can increase a peak value of emitted pulsed light.

However, the VCSEL described in Japanese Patent Laid-open Publication No. 2022-176886 still has room for further improvement.

### SUMMARY

The present disclosure is directed to a light emitting element improved further than the light emitting element described in Japanese Patent Laid-open Publication No. 2022-176886, and to a distance measuring apparatus using the improved light emitting element.

One aspect of the present disclosure provides a light emitting element as specified in claim 1. Optional features are specified in claims 3 to 18.

Further, another aspect of the present disclosure provides a light emitting element as specified in claim 2. Optional features are specified in claims 3 to 10, 12 to 14, and 16 to 18.

Still another aspect of the present disclosure provides a distance measuring apparatus as specified in claim 19.

Yet another aspect of the present disclosure provides a movable body as specified in claim 20.

Features of the present disclosure will become apparent from the following description of embodiments with reference to the attached drawings. The following description of embodiments is described by way of example.

### BRIEF DESCRIPTION OF THE DRAWINGS

Fig. 1 is a cross-section diagram schematically illustrating a configuration of a light emitting element according to a first embodiment.
Fig. 2 is a band diagram illustrating a vicinity of an active layer of the light emitting element according to the first embodiment.
Fig. 3 is a graph illustrating a relationship between light extraction efficiency and band gap difference according to the first embodiment.
Fig. 4 is a graph illustrating a relationship between current and emission spectrum of the light emitting element according to the first embodiment.
Fig. 5 is a band diagram illustrating a vicinity of an active layer of a light emitting element according to a modification example of the first embodiment.
Fig. 6 is a band diagram illustrating a vicinity of an active layer of a light emitting element according to another modification example of the first embodiment.
Fig. 7 is a cross-section diagram schematically illustrating a configuration of a light emitting element according to a second embodiment.
Fig. 8 is a cross-section diagram schematically illustrating a configuration of a light emitting element according to a third embodiment.
Fig. 9 is a cross-section diagram schematically illustrating a configuration of a light emitting element according to a fourth embodiment.
Fig. 10 is a band diagram illustrating a vicinity of an active layer of a light emitting element according to a fifth embodiment.
Fig. 11A is a band diagram illustrating the vicinity of the active layer of the light emitting element according to a sixth embodiment.
Fig. 11B is a band diagram illustrating a vicinity of an active layer of a light emitting element according to another example of the sixth embodiment.
Fig. 12A is a band diagram illustrating the vicinity of the active layer of the light emitting element according to the sixth embodiment.
Fig. 12B is a graph illustrating a distribution calculation example in the vicinity of the active layer of the light emitting element according to the sixth embodiment.
Fig. 13A is a graph illustrating a calculation example in the vicinity of the active layer of the light emitting element according to the sixth embodiment.
Fig. 13B is a graph illustrating a calculation example in the vicinity of the active layer of the light emitting element according to the sixth embodiment.
Fig. 14 is a graph illustrating a calculation example in the vicinity of the active layer of the light emitting element according to the sixth embodiment.
Fig. 15A is a graph illustrating a calculation example in the vicinity of the active layer of the light emitting element according to the sixth embodiment.
Fig. 15B is a graph illustrating a calculation example in the vicinity of the active layer of the light emitting element according to the sixth embodiment.
Fig. 16 is a graph illustrating a calculation example in the vicinity of the active layer of the light emitting element according to the sixth embodiment.
Fig. 17 is a cross-section diagram schematically illustrating a configuration of a light emitting element according to a seventh embodiment.
Fig. 18 is a block diagram schematically illustrating a configuration of a distance measuring apparatus according to an eighth embodiment.
Fig. 19A is a cross-section diagram schematically illustrating a configuration of a light emitting element according to a comparative example.
Fig. 19B is a band diagram illustrating a vicinity of an active layer of the light emitting element according to the comparative example.

### DESCRIPTION OF THE EMBODIMENTS

Embodiments described below are to embody the technological thought of the present disclosure and are not intended to limit the present disclosure. The sizes and positional relationships of components illustrated in each diagram may sometimes be exaggerated to clarify the descriptions. In the descriptions below, the same numerals are assigned to the same components, and sometimes duplicate descriptions thereof may be omitted.

Hereinbelow, the embodiments of the present disclosure will be described with reference to the attached drawings. In the following descriptions, terms indicating specific directions or positions (e.g., "upper", "lower", "right", "left", and other terms including them) may be used as needed. These terms are used to facilitate understanding of the embodiments with reference to the drawings, and the technical scope is not limited by the meaning of these terms. For example, for a vertical cavity surface emitting laser (VCSEL), terms such as a lower reflection mirror, an upper reflection mirror, a lower electrode, and an upper electrode are used, but these terms are expressions used merely to specify the relative relationships. Accordingly, in a case where the light emitting element is attached upside down, the reflection mirror located on the upper side can be referred to as a "lower reflection mirror" and the reflection mirror located on the lower side can be referred to as an "upper reflection mirror".

Hereinbelow, descriptions are given by defining a first conductivity type semiconductor as an n-type semiconductor, and a second conductivity type semiconductor having a conductivity type opposite to that of the first conductivity type semiconductor, as a p-type semiconductor. However, the first conductivity type semiconductor may be a p-type semiconductor, and the second conductivity type semiconductor may be an n-type semiconductor. In addition, a non-doped or an undoped semiconductor can be referred to as an i type semiconductor, and the i type semiconductor can be referred to as a third conductivity type semiconductor.

In the present specification, in a case where a term "doping concentration" is simply used, it means a net doping concentration that is obtained by subtracting an amount compensated by opposite conductivity type impurities. In other words, the "doping concentration" refers to a net doping concentration. A region in which the p-type additive doping concentration is higher than the n-type additive doping concentration is a p-type semiconductor region. On the other hand, a region in which the n-type additive doping concentration is higher than the p-type additive doping concentration is an n-type semiconductor region.

Further, in the present specification, the i type semiconductor includes not only a semiconductor with a net doping concentration of 0, but also a semiconductor with a net doping concentration of 1.0 × 10¹⁵ cm⁻³ or less.

### [Comparative Example]

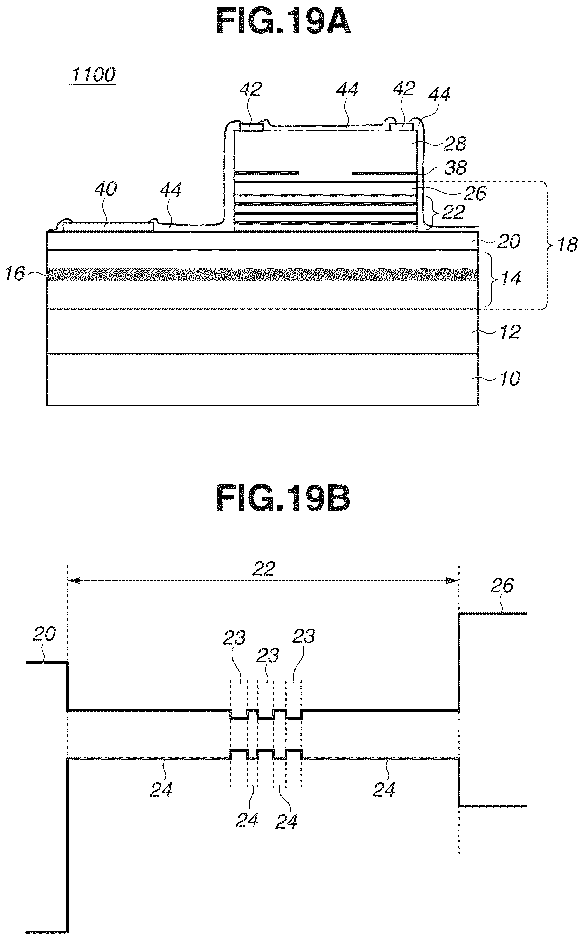

Before describing a first embodiment of the present disclosure, a comparative example will be described with reference to Figs. 19A and 19B. Fig. 19A is a cross-section diagram schematically illustrating a configuration of the comparative example.

A light emitting element 1100, which is the comparative example, includes a semiconductor substrate 10, a lower reflection mirror 12 (first reflection mirror), a spacer portion 14, an upper reflection mirror 28 (second reflection mirror), electrodes 40 and 42, and protective films 44. The lower reflection mirror 12 is provided on the semiconductor substrate 10. The spacer portion 14 is provided on the lower reflection mirror 12. The upper reflection mirror 28 is provided on a resonator 18. A layer located between the lower reflection mirror 12 and the upper reflection mirror 28 is the resonator 18.

In the spacer portion 14, a saturable absorption layer 16 is provided. An n-type layer 20 is provided on the spacer portion 14, an active layer 22 is provided on the n-type layer 20, and a p-type layer 26 is provided on the active layer 22. The active layer 22 includes three quantum well layers. An oxide confinement layer 38 is provided in the upper reflection mirror 28.

The active layer 22, the p-type layer 26, and the upper reflection mirror 28 are etched in a mesa shape. On the n-type layer 20 the electrode 40 electrically connected to the n-type layer 20 is provided. The n-type layer 20 was exposed by processing the active layer 22, the p-type layer 26, and the upper reflection mirror 28 in a mesa shape. On the upper reflection mirror 28, electrodes 42 electrically connected to the upper reflection mirror 28 are provided. The protective films 44 are provided on the upper surface of the n-type layer 20 excluding at least a part of the surfaces of the electrodes 40 and 42, and on side surfaces and an upper surface of the mesa.

The semiconductor substrate 10 can be, for example, a gallium arsenide (GaAs) substrate. The lower reflection mirror 12 is composed of, for example, 35 laminated layer pairs each consisting of a laminated layer pair of an Al_{0.1}GaAs layer and an Al_{0.9}GaAs layer each layer having an optical film thickness of 1/4 λc. Here, λc is a center wavelength of a highly reflective frequency band of the lower reflection mirror 12. For example, λc is 940 nm.

The saturable absorption layer 16 can be configured of, for example, a multiple quantum well including three layers of quantum wells each obtained by sandwiching an indium gallium arsenide (InGaAs) well layer with a thickness of 8 nm by an aluminum gallium arsenide (AlGaAs) barrier layers each with a thickness of 10 nm. Other portions of the spacer portion 14 can be composed of non-doped GaAs layers.

As described above, a p-i-n junction consisting of the n-type layer 20, the active layer 22, and the p-type layer 26 is formed.

Fig. 19B is a band diagram illustrating the n-type layer 20, the active layer 22, and the p-type layer 26. For example, the active layer 22 can be configured of quantum wells each obtained by sandwiching each of quantum well layers 23 made of InGaAs by barrier layers 24 made of AlGaAs. The n-type layer 20 can be composed of an n-type GaAs layer, and the p-type layer 26 can be composed of a p-type GaAs layer.

With reference to Japanese Patent Laid-open Publication No. 2022-176886, as the barrier layers 24, AlGaAs with an Al composition of 0.1 or less can be employed. The energy difference between the band gap of the AlGaAs barrier layer with the Al composition of 0.1, and the emission level of the InGaAs well layer with a light emission wavelength of 940 nm is 230 meV. Thus, the energy difference between the band gap of each of the barrier layers 24 and the emission level of the well layer may be 230 meV or less.

Referring back to Fig. 19A, the upper reflection mirror 28 can be composed of, for example, 20 pairs of laminated layers each including a laminated pair of an Al_{0.1}Ga_{0.9}As layer and an Al_{0.9}Ga_{0.1}As layer each layer having an optical thickness of 1/4λc. In the upper reflection mirror 28, the oxide confinement layer 38 made by oxidizing a part of an Al_{0.98}Ga_{0.02}As layer with a thickness of 30 nm is provided. For example, the oxide confinement layer 38 can be formed by oxidizing the Al_{0.98}Ga_{0.02}As layer using water vapor from the side surface of the mesa at its manufacturing time. The oxide confinement layer 38 is an oxidized portion near the side wall of the mesa, and the center portion of the mesa, which is located inside the oxidized portion is a non-oxidized portion. Since the current input to the light emitting element 1100 flows only through the non-oxidized portion due to the oxide confinement layer 38, the light emitting element 1100 performs laser oscillation at only a part overlapping the center portion of the mesa in a planar view.

The saturable absorption layer 16 is introduced into the light emitting element 1100 according to the comparative example using the normal VCSEL configuration as a base. During a certain time period from the current input start time, the oscillation is obstructed by the absorption of light by the saturable absorption layer 16. When the light is absorbed by the saturable absorption layer 16, the absorbed light is accumulated in the saturable absorption layer 16 as carriers. The carriers increase as the light is absorbed, and when the carrier density in the saturable absorption layer 16 reaches the transparent carrier density, the saturable absorption layer 16 stops absorbing the light. Then, the effect of obstructing the laser oscillation is lost, and the light emitting element 1100 starts the laser oscillation.

The laser oscillation is obstructed by the saturable absorption layer 16 during a certain time period to accumulate carriers exceeding a threshold carrier density in the active layer 22. In this case, the threshold carrier density is a carrier density that can generate a gain required for performing laser oscillation.

The carrier density of the active layer 22 starts rising when the input of the current starts. In the state before starting the laser oscillation, the carriers continue being accumulated temporarily exceeding the threshold carrier density. Then, when the laser oscillation starts, the carriers are rapidly consumed by stimulated emission, and converge to a stable value. In this way, light pulses with high peak values and short half-value widths can be emitted.

The active layer 22 can accumulate carriers more than or equal to the threshold carrier density because the laser oscillation is suppressed for a certain time period using the saturable absorption layer 16. By achieving such a high carrier density, the light pulses with high peak values and short pulse widths can be generated in the light emitting element 1100.

The condition under which laser oscillation continues after generation of a light pulse is that the maximum gain obtainable from the active layer 22 exceeds the absorption in the resonator as a whole. More specifically, the laser oscillation can be continued when a relationship expressed by formula (1) is satisfied. In formula (1), Γa is a light confinement factor of the saturable absorption layer 16, Γs is a light confinement factor of the active layer 22, and gmax(lop) is a maximum gain of the active layer 22 obtained when the current value is lop. Further, α2 is an absorption coefficient of the saturable absorption layer 16, αm is a mirror loss, and αi is a light absorption by the carriers or the like of the semiconductor. $Γs \times gmax \left(lop\right) > Γa \times α 2 + αm + αi$

### [Issue of Comparative Example]

As described above, in order to output light pulses with high peak values and short half-value widths, carriers more than or equal to the threshold carrier density are accumulated in the active layer 22. For this reason, as illustrated in Fig. 19B, the total thickness of the barrier layers 24 between the n-type layer 20 and the quantum well layers 23, the barrier layers 24 between the p-type layer 26 and the quantum well layers 23, and the barrier layers 24 between the quantum well layers 23 becomes a predetermined thickness or more so as to be able to accumulate carriers.

However, in the n-type layer 20, a nonradiative recombination center may be generated in the band gap due to the impurities. Further, the impurities may spread in a part of the barrier layers 24 adjacent to the n-type layer 20, and there is a possibility that a nonradiative recombination center may be generated also in the barrier layers 24 adjacent to the n-type layer 20. Thus, there is a possibility that the carriers are consumed in the barrier layers 24 for accumulating the carriers, and the light pulses may have relatively low peak values. Similarly, when the p-type layer 26 and the barrier layers 24 are arranged side by side, there may be a possibility that the carriers are consumed in the barrier layers 24 adjacent to the p-type layer 26, and the light pulses have relatively low peak values.

### [First Embodiment]

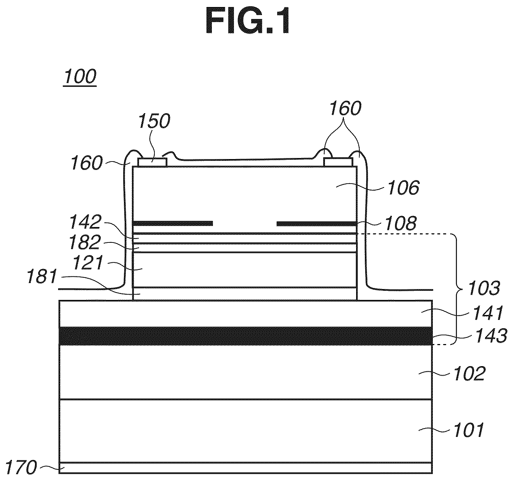

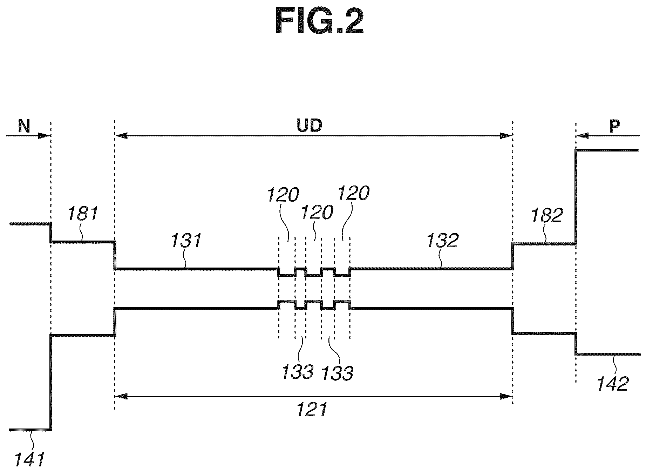

Fig. 1 is a cross-section diagram schematically illustrating a configuration of a light emitting element 100 according to a first embodiment. Further, Fig. 2 is a band diagram illustrating a vicinity of an active layer of the light emitting element 100. Different from the comparative example, a first spacer layer 181 is provided between an n-type first doped layer 141 and a first barrier layer 131. Further, a second spacer layer 182 is provided between a p-type second doped layer 142 and a second barrier layer 132.

In Fig. 1, on a semiconductor substrate 101, a lower reflection mirror 102 (first reflection mirror), a saturable absorption layer 143, a n-type first doped layer 141, and a first spacer layer 181 are provided in this order.

For example, the lower reflection mirror 102 may have a configuration similar to the lower reflection mirror 12 in the comparative example. Further, the saturable absorption layer 143 may have a configuration similar to the saturable absorption layer 16 in the comparative example. As in the comparative example, a spacer portion may be provided on the upper side or the lower side of the saturable absorption layer 143, or spacer portions may be provided on both of the upper side and the lower side of the saturable absorption layer 143, respectively. By providing the spacer portion or portions, it is possible to make the resonator longer, which allows adjusting the widths of the light pulses.

The first spacer layer 181 may be an undoped semiconductor layer, or it may be a semiconductor layer. The first layer 181 may have a doping concentration lower than that of the n-type first doped layer 141. By providing the first spacer layer 181, it is possible to reduce the consumption of carriers, and to prevent the peak values of the light pulses from becoming low.

On the first spacer layer 181, an active layer 121 is provided. As illustrated in Fig. 2, the active layer 121 may be provided with three quantum well layers 120 so as to be sandwiched between the first barrier layer 131 and the second barrier layer 132. At a position between every two quantum well layers 120, one of third barrier layers 133 may be provided. That is to say that a third barrier layer 133 may be provided to separate two quantum well layers 12. Further, on the active layer 121, the second spacer layer 182 and the second doped layer 142 may be provided.

Preferably, the first doped layer 141 is an n-type Al_{0.9}Ga_{0.1}As layer.

Preferably, the first spacer layer 181 is a 30 nm thick Al_{0.3}Ga_{0.7}As layer. The first spacer layer 181 may be an undoped semiconductor layer, or it may be a semiconductor layer. The first space layer 181 may have a doping concentration lower than that of the first doped layer 141. By providing the first spacer layer 181, it is possible to reduce the consumption of carriers, and to prevent the peak values of the light pulses from becoming low.

The layer thickness of the first spacer layer 181 may be 5 nm or more, or 10 nm or more to prevent the impurity diffusion from the first doped layer 141. On the other hand, a certain film thickness needs to be secured to accumulate carriers in the barrier layers. Thus, if the first spacer layer 181 is formed too thick, there may be possibilities that the thicknesses of the barrier layers are restricted, the electric resistance increases, and carriers are less easily injected into the active layer 121. Thus, taking these points into consideration, the thickness of the first spacer layer 181 may be 100 nm or less, or 50 nm or less. That is to say, the thickness of the first spacer layer 181 may be in the range of 5nm to 100nm, or 5nm to 50 nm, or 10 nm to 100 nm or 10 nm to 50 nm. It should be understood that when a specific value is stated, there is preferably some tolerance provided and as such should be interpreted as being approximately the specified value or value for ranges, for example approximately 5 nm or about 5 nm. The amount of tolerance will be to achieve substantially the same technical result.

Preferably, each of the quantum well layers 120 is an 8 nm thick non-doped InGaAs layer. Preferably, each of the first barrier layer 131 and the second barrier layer 132 is a 50 nm thick non-doped GaAs layer. Preferably, each of the third barrier layers 133 is a 10 nm thick non-doped GaAs layer.

Each of the first barrier layer 131, the second barrier layer 132, and the third barrier layers 133 may be also an AlGaAs layer instead of the GaAs layer. However, by using the GaAs layer for each barrier layer, the band gap of each barrier layer can be made smaller than the case of using the AlGaAs layer. As a result, carriers can be accumulated more in the GaAs barrier layers. To accumulate carriers in each barrier layer, the energy difference between the energy (also can be referred to as a band gap of the active layer) of photons with the oscillation wavelength, and a band gap of each barrier layer may be 230 meV or less. Under the condition to accumulate carriers in the barrier layers, spacer layers may be provided between the first doped layer 141 and the first barrier layer 131, and between the second doped layer 142 and the second barrier layer 132. In this way, it is possible to reduce the consumption of carriers, and to prevent the peak values of the light pulses from becoming low.

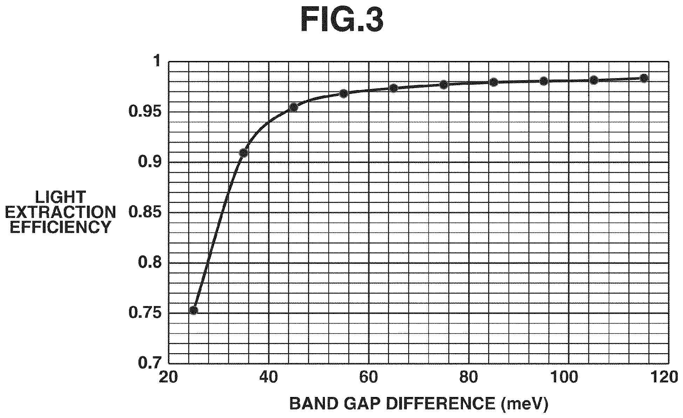

As described above, for the purpose of accumulating carriers in the barrier layers, the band gap difference between the active layer and the barrier layer is desirably 230 meV or less. On the other hand, from a view point of preventing the light absorption by the semiconductors configuring the barrier layers, the band gap difference may need to be a predetermined value or more. As an example, Fig. 3 illustrates a result of calculating the light-extraction efficiency using the wavelength dependency of an absorption coefficient of a GaAs layer when the barrier layers are the GaAs layers. Fig. 3 illustrates the calculation result of the band gap difference dependency of the light extraction efficiency between the barrier layer and the quantum well layer. The vertical axis represents the light extraction efficiency, and the horizontal axis represents the band gap difference. In the vertical axis, the light extraction efficiency when there is no light absorption by the GaAs is set to 1 (100%). In a case where the band gap difference between the barrier layer and the quantum well is 105 meV, the light extraction efficiency reduces by 2% compared with a case where there is no absorption by the band gap. Similarly, in a case where the band gap differences each between the barrier layer and the quantum well layer are 60 meV, 48 meV, and 44 meV, the light extraction efficiencies respectively decrease by 3%, 4%, and 5% compared with the case where there is no absorption by the band gap. Focusing on these differences, the band gap difference between the 2% reduction and the 3% reduction is 45 meV, which is relatively large. However, the band gap difference between the 3% reduction and the 4% reduction is 12 meV, and the band gap difference between the 4% reduction and 5% reduction is 4 meV. In this way, the band gap differences become smaller rapidly.

In ternary or higher compound semiconductors, the rough target controllability of the elemental composition at a crystal growth time is about 1%, which can be achieved easily. Then, the change amount of the band gap when the composition changes by 1% is 12 meV in the AlGaAs based semiconductors, and 14 meV in the InGaAs based semiconductors. The energy difference when the composition changes by 1% and the energy difference when the above-described light extraction efficiency changes from 3% to 4% are substantially the same. For this reason, taking the composition change amount of 1% at the crystal growth time into consideration, the band gap difference may need to be 60 meV or more corresponding to the design value with which the reduction of the above-described light extraction efficiency is 3%. In this way, the characteristic stability of the element can be maintained even if the production error occurs at an actual crystal growth time.

In order to keep the reduction of the light extraction efficiency to 2% or less with an emphasis on preventing the influence by the light absorption at the band end while accumulating carriers in the barrier layers, the band gap difference may be within a range from 105 meV or more and 230 meV or less. Further, in a case where the light extraction efficiency reduction of about 4% by the light absorption at the band end is tolerable, the band gap difference may be within a range from 60 meV or more and 230 meV or less, taking also the controllability at the crystal growth time into consideration.

In addition, even in a case where compound semiconductor materials different from those described above are used, since the wavelength dependency of the absorption coefficient for the wavelengths of the band gap or less does not change largely in direct transition type semiconductor materials, the values described above can be applied.

In order to accumulate a required amount of carriers also in the barrier layers in addition to the quantum well layers 120, at least one of the thicknesses of the first barrier layer 131 and the second barrier layer 132 may be set to 50 nm or more.

The layer thickness Tb of the barrier layer can be expressed by formula (2). $Tb \geq \left\{\left(Q-N\right)\times Tq/Rc-Tbq\times \left(N-1\right)\right\} / 2$

In formula (2), Q represents the effective number of quantum wells required in a case where a high peak value ratio R or more is required, Rc represents a carrier density ratio between the quantum well layer and the barrier layer, Tq represents a thickness of one layer of the quantum well layers, Tbq represents a thickness of the barrier layer between the quantum well layers, and N represents the number of quantum wells. The effective number of quantum wells is the number of quantum well layers expressing the total carrier amount accumulated in the active layer, including the carrier amount accumulated in the quantum well layers and the barrier layers using a ratio to the carrier amount accumulated in one layer of the quantum well layers.

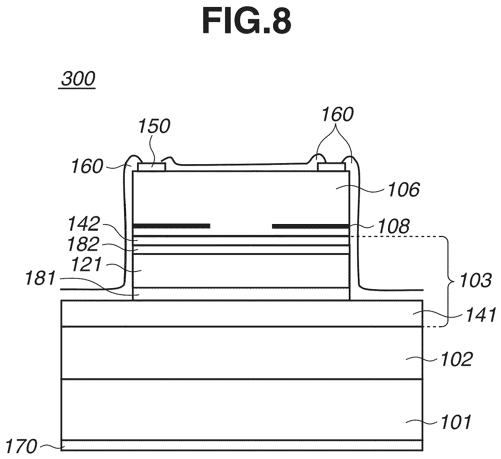

Hereinbelow, a description will be given specifically. A required high peak value ratio is determined depending on the intended use of the light emitting element 100 according to the present embodiment. For example, in a case where a high peak value ratio R or more is required, from Fig. 8 in Japanese Patent Laid-open Publication No. 2022-176886, the effective number Q of quantum wells in terms of the number of quantum wells is determined as the amount required for accumulating carriers.

In a case where the actual number of quantum wells is N, carriers corresponding to (Q - N) quantum well layers 120 need to be accumulated in the barrier layers. When Tq is a thickness of one layer of the quantum well layers 120, and Rc is a ratio of the carrier density between the quantum well layers 120 and the barrier layers, a total thickness of the required barrier layers (i.e., total thickness of the first barrier layer, the second barrier layer, and the third barrier layers) can be described by formula (3). $\left(Q-N\right) \times Tq / Rc$

In formula (3), when Tbq is a thickness of the barrier layer between the quantum well layers (i.e., thickness of each of the third barrier layers 133), the layer thickness Tb of the first barrier layer 131 or the second barrier layer 132 is as represented by formula (2) described above.

As an example, when a high peak value ratio is to be 3 or more, and the effective resonator length is 2 µm, the required effective number Q of the quantum wells becomes 6 in terms of the number of quantum wells, from Fig. 8 in Japanese Patent Laid-open Publication No. 2022-176886. In a case where the actual number of quantum wells is 3, it is necessary to accumulate carriers corresponding to (6 - 3) = 3 quantum wells as the remaining carriers in the first barrier layer 131, the second barrier layer 132, and the third barrier layers 133.

From Fig. 2 in Japanese Patent Laid-open Publication No. 2022-176886, in a case where the carrier density is 2.0 × 10¹⁸ cm⁻³, and the barrier layers are made of GaAs, the ratio Rc of the carrier density between the quantum wells and the barrier layers becomes 0.2. Thus, the total thickness of the required barrier layers is 25 nm/0.2 = 125 nm, in a case where the thickness corresponding to the three quantum well layers is 25 nm.

In a case where the thickness of each of the third barrier layers 133 between the quantum well layers 120 is 10 nm, and the three quantum well layers 120 are located at the center of the active layer 121, the thickness of each of the first barrier layer 131 and the second barrier layer 132 becomes (125 - 10 × 2)/2 = 50.25 nm.

The above description is about the case where the quantum well layers 120 are located at the center of the active layer 121, but in a case where the quantum well layers 120 are not located at the center of the active layer 121 and shifted, any one of the first barrier layer 131 and the second barrier layer 132 becomes thinner than the above-described value, and the other one becomes thicker by the thickness corresponding thereto. In any case, any one of the first barrier layer 131 and the second barrier layer 132 may have a film thickness of 50 nm or more. In a case where the required high peak value ratio is set larger in a similar configuration, the required thickness of the barrier layer becomes thicker.

In Fig. 2, the film thickness of the first barrier layer 131 and the film thickness of the second barrier layer 132 are the same, but the film thickness of the first barrier layer 131 and the film thickness of the second barrier layer 132 may be different so as to be able to adjust the positions of the antinodes and the nodes of the standing wave, and the positions of the quantum well layers 120.

The configuration of actively accumulating carriers in the barrier layers has a secondary effect, in addition to the effect described above. The effect is that the consumption amount of carriers due to the radiative recombination can be reduced. In all the semiconductors having the quantum well layers and the barrier layers, in a case where carriers of both holes and electrons exist at the same time, carriers are consumed due to the radiative recombination (spontaneous emission). In the case of the semiconductor laser, when the consumption amount of carriers becomes large due to the radiative recombination (spontaneous emission), the threshold value for the laser oscillation rises to lower the power conversion efficiency, which is undesirable. It is known that the radiative recombination amount is proportional to the square of the carrier density. Thus, even in a case where the same amount of carriers is accumulated, the carrier density, i.e., the amount of carriers consumed due to the radiative recombination changes depending on the volume of the portion for accumulating the carriers.

For example, the second spacer layer 182 is a 30 nm thick Al_{0.3}Ga_{0.7}As layer. The second spacer layer 182 is undoped or has a doping concentration lower than that of the second doped layer 142. By providing the second spacer layer 182, it is possible to reduce the consumption of carriers, and to prevent the peak values of the light pulses from becoming low.

The layer thickness of the second spacer layer 182 can be 5 nm or more, or 10 nm or more to prevent the impurity diffusion from the second doped layer 142. On the other hand, a certain film thickness needs to be secured to accumulate carriers in the barrier layers. Thus, if the second spacer layer 182 is formed too thick, there may be a possibility that the thicknesses of the barrier layers are restricted, the electric resistance increases, and carriers are less easily injected into the active layer 121. Thus, taking these points into consideration, the thickness of the second spacer layer 182 can be 100 nm or less, or 50 nm or less. That is to say, the thickness of the second space layer 182 may be in the range of 5nm to 100n m, or 5 nm to 50 nm, or 10 nm to 100 nm or 10 nm to 50 nm.

As described above, the thickness of the first barrier layer 131 or the second barrier layer 132 can be 50 nm or more. Further, the thickness of the spacer layer can be 5 nm or more and 100 nm or less, or 10 nm or more and 50 nm or less. In this case, the ratio of the thickness of each barrier layer to the thickness of the spacer layer becomes 0.5 or more and 10 or less in the former case, and 1 or more and 5 or less in the latter case.

Preferably, the second doped layer 142 is a p-type Al_{0.9}Ga_{0.1}As layer.

On the second doped layer 142, an upper reflection mirror 106 (second reflection mirror) including an oxide confinement layer 108 may be provided. A portion sandwiched between the upper reflection mirror 106 and the lower reflection mirror 102 may be a resonator 103.

The oxide confinement layer 108 may have a configuration similar to the oxide confinement layer 38 in the comparative example. The upper reflection mirror 106 may have a configuration similar to the upper reflection mirror 28 in the comparative example.

Two electrodes may be provided, with each electrode being provided on different parts. An upper electrode 150 may be provided on the upper reflection mirror 106. A lower electrode 170 may be provided on the lower side of the semiconductor substrate 101. Further, a protective film 160 may be provided, preferably on the upper electrode 150 and the side wall of the mesa.

Different from the comparative example, the lower electrode 170 may be provided on the lower side of the semiconductor substrate 101 in Fig. 1. Thus, the lower reflection mirror 102 and the saturable absorption layer 143 are made of, for example, n-type semiconductors.

However, since defects may be introduced in the quantum well layers 120 when the impurities are doped, the quantum well layers 120 may be non-doped semiconductor layers. Preferably, for the same reason, the third barrier layers 133 may be non-doped semiconductor layers. Preferably, for the same reason, all of or a part of the first barrier layer 131 may be a non-doped semiconductor layer, and all of or a part of the second barrier layer 132 may be a non-doped semiconductor layer.

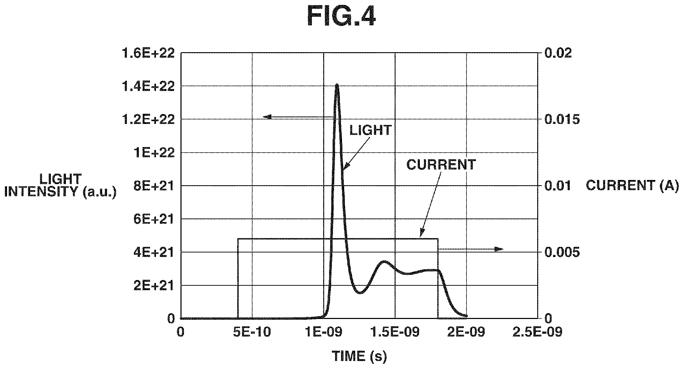

Fig. 4 is a graph illustrating a relationship between current and light intensity of a light emitting element produced using the present embodiment.

The light emitting element has a profile including a maximum peak value, and after the maximum peak value, the light intensity converges to a stable value, which is a predetermined light intensity. The condition for the continuation of the laser oscillation after the generation of the light pulses is as described above in the comparative example.

With the configuration described above, since the first spacer layer 181 and the second spacer layer 182 are provided, it is possible to reduce the consumption of carriers, and to prevent the peak values of the light pulses from becoming low.

### [Modification Example]

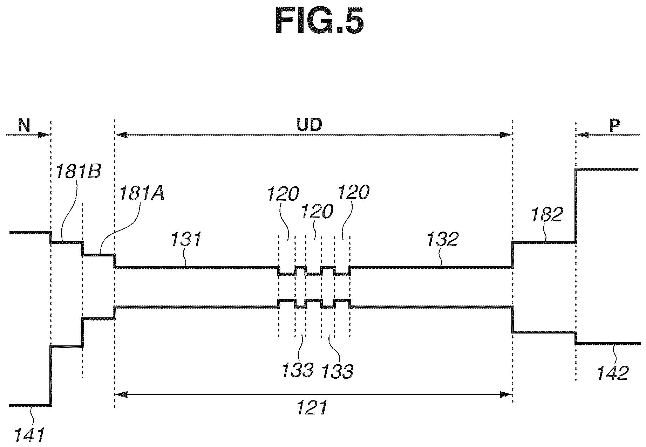

Fig. 5 is a band diagram illustrating a vicinity of an active layer of a light emitting element according to a modification example of the first embodiment. The light emitting element in Fig. 5 is different from the light emitting element 100 in Fig. 1 in that a spacer layer separated into two spacer layers 181A and 181B is used as the first spacer layer. In Fig. 5, the spacer layer 181A is a 15 nm thick Al_{0.2}Ga_{0.8}As layer, and the spacer layer 181B is a 15 nm thick Al_{0.4}Ga_{0.6}As layer. In this manner, by arranging the spacer layer disposed between the barrier layer and the doped layer as a plurality of layers including two or more layers, it becomes easier, for example, to additionally impart another function to one of the layers. For example, a layer having a strain-compensation function with a thickness of about 10 nm and a lattice constant that is easy to control, and another layer, can be combined so as to function as the spacer layer. The arrangement of the space layer disposed between the barrier layer and the doped layer may be a plurality of layers including two of more layers, preferably with each of the two or more layers having different thicknesses, more preferably reducing in thickness from the barrier layer to the doped layer, i.e. from doped layer 141 to barrier layer 131.

In Fig. 5, the spacer layer corresponding to the first spacer layer 181 includes the plurality of layers. However, the second spacer layer 182 may be divided into a plurality of layers, or each of the first spacer layer 181 and the second spacer layer 182 may be divided into a plurality of layers. That is to say, the second spacer layer 182, may comprise a plurality of layers, preferably each layer of the plurality of layers forming the second spacer layer may have different thicknesses. In some embodiments, either the first spacer layer or second spacer layer that comprises a plurality of layers, preferably each layer of the plurality of layers having a different thickness, more preferably wherein the thickness reduces from the dopped layer to the barrier layer. In other embodiments, both the first spacer layer and second spacer layer comprise a plurality of layers, preferably each layer of the plurality of layers having a different thickness, more preferably wherein the thickness reduces from the dopped layer to the barrier layer.

In the modification example in Fig. 5, it is possible to reduce the consumption of carriers, and to prevent the peak values of the light pulses from becoming low. In this case, it is possible to achieve the effect by making at least one of the plurality of spacer layers be a configuration according to a design guide to be described in and after a second embodiment.

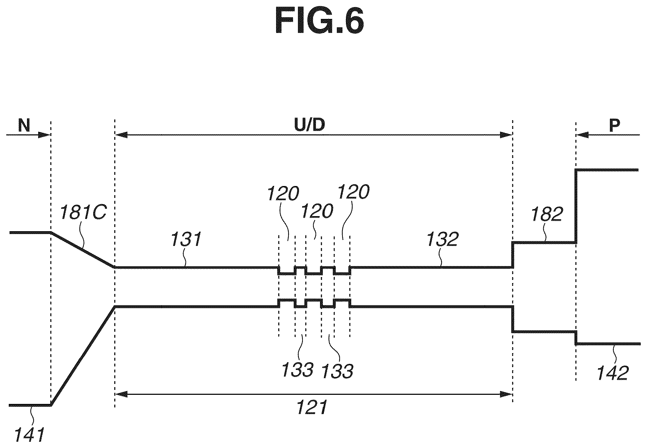

Fig. 6 is a band diagram illustrating a vicinity of an active layer of a light emitting element according to another modification example of the first embodiment. A light emitting element in Fig. 6 is different from the light emitting element 100 in Fig. 1 in that a layer in which the band gap changes continuously, so-called a graded layer, is used as a first spacer layer 181C. Since the potential wall is eliminated by using the graded layer, there is an advantage that the resistance is reduced, and accordingly the driving voltage is reduced.

As illustrated in Fig. 6, the band gap at an end of the first spacer layer 181C can be the same as the band gap of the first doped layer 141, and the band gap at the other end of the first spacer layer 181C can be the same as the band gap of the first barrier layer 131.

In addition, Fig. 6 illustrates the example in which the band gaps on both sides of the graded layer are respectively the same as the band gaps of the first doped layer 141 and the first barrier layer 131, but the band gaps are not limited thereto, and the band gaps may be different band gaps. In a case where the spacer layer arranged between the barrier layer 131 and the doped layer 141 is formed to be a graded layer, at least a part of the graded layer has a band gap between the first barrier layer 131 and the doped layer 141 sandwiching the graded layer, and the carrier density especially achieves the effect performing design according to the design guide described in each embodiment.

In Fig. 6, only the first spacer layer 181C is formed to be a graded layer, but instead, only the second spacer layer 182 may be configured of a graded layer, or both of the first spacer layer 181C and the second spacer layer 182 may be configured of graded layers.

As in the modification example in Fig. 6, in the case where the spacer layer arranged between the barrier layer and the doped layer is configured of a graded layer, it is possible to reduce the consumption of carriers, and to prevent the peak values of the light pulses from becoming low.

Either one of the first spacer layer 181 and the second spacer layer 182 may be provided, which will be described in an embodiment below. Even in this case, the technical effect of reducing the consumption of carriers can be achieved.

Further, the doped layer may be a part of the lower reflection mirror or the upper reflection mirror, for example, as described in an embodiment below. More specifically, it is sufficient that the doped layer is provided on a surface of the active layer 121 on the semiconductor substrate side, or on a surface of the active layer 121 opposite thereto, and the doped layer may not be provided between the upper reflection mirror and the barrier layers, or between the lower reflection mirror and the barrier layers.

Further, if the light emitting element is configured to be able to emit light with high peak values, the saturable absorption layer may not necessarily be provided, for example, as described in an embodiment below.

### [Second Embodiment]

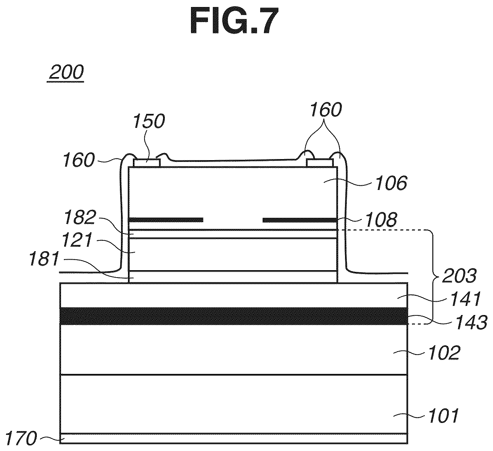

A light emitting element 200 according to a second embodiment will be described with reference to Fig. 7. Fig. 7 is a cross-section diagram schematically illustrating a configuration of the light emitting element 200 according to the present embodiment.

The present embodiment is different from the above-described embodiments in that the second doped layer 142 is not provided between the second spacer layer 182 and the upper reflection mirror 106. In other words, the second doped layer 142 is not provided in a resonator 203. In this case, a layer of a multilayer film included in the upper reflection mirror 106 corresponds to the second doped layer 142.

More specifically, for example, the upper reflection mirror 106 may be configured of 20 laminated layer pairs each consisting of a laminated layer pair of an Al_{0.1}Ga_{0.9}As layer and an Al_{0.9}Ga_{0.1}As layer each layer having an optical film thickness of 1/4λc. Preferably, in a case where the lowermost layer of the upper reflection mirror 106 is an Al_{0.9}Ga_{0.1}As layer, the lowermost layer is the second doped layer 142. Preferably, the lowermost layer of the upper reflection mirror 106 may be configured of a layer having a composition different from that of a large number of low refractive index layers constituting the upper reflection mirror 106. Even in this case, the lowermost layer of the upper reflection mirror 106 is the second doped layer 142.

The band diagram in Fig. 2 described above can be applied to the present embodiment. Thus, since the present embodiment includes the first spacer layer 181 and the second spacer layer 182, it is possible to reduce the consumption of carriers, and to prevent the peak values of the light pulses from becoming low. In other embodiments, the band gaps diagrams described in reference to other Figures may be applied to the present embodiment.

### [Third Embodiment]

A light emitting element 300 according to a third embodiment will be described with reference to Fig. 8. Fig. 8 is a cross-section diagram schematically illustrating a configuration of the light emitting element 300 according to the present embodiment.

In the present embodiment, a configuration without the saturable absorption layer 143 is employed. Instead, a method of generating light pulses with high peak values and short pulse widths in the light emitting element 300 can be appropriately employed.

More specifically, the degree of injection of electrons and holes in the active layer 121 may be configured to be non-uniform in the lamination direction. In other words, in a case where the light emitting element 300 includes a plurality of quantum well layers, the carrier amounts are made non-uniform between the lower quantum well layer and the upper quantum well layer. For example, when the number of the quantum well layers is increased, the carriers to be recombined are accumulated on the hole injection side due to the difference of mobility between the electrons and the holes, and the amounts of the carriers become non-uniform. Preferably, by providing a hole-blocking layer to interfere with the movement of the holes in the active layer, the degree of injection of the electrons and the holes can be made non-uniform. Preferably, as described in United States Patent Application Publication No. 2014/0169397, it is possible to generate the light pulses with high peak values and short pulse widths in the light emitting element 300 even if a configuration in which the positions of the quantum well layers are largely shifted from the antinodes of a standing wave is employed.

Other configurations are the same as those of the first embodiment. Thus, since the light emitting element 300 includes the first spacer layer 181 and the second spacer layer 182 also in the present embodiment, it is possible to reduce the consumption of carriers, and to prevent the peak values of the light pulses from becoming low.

### [Fourth Embodiment]

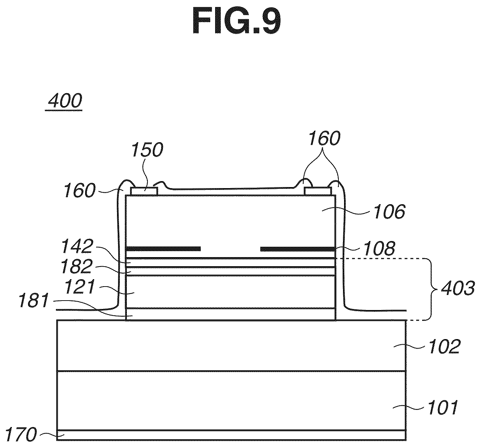

A light emitting element 400 according to a fourth embodiment will be described with reference to Fig. 9. Fig. 9 is a cross-section diagram schematically illustrating a configuration of the light emitting element 400 according to the present embodiment.

The present embodiment is different from the third embodiment in that the first doped layer 141 is not provided between the lower reflection mirror 102 and the first spacer layer 181. In other words, the first doped layer 141 is not provided in a resonator 403. In this case, a layer of a multilayer film included in the lower reflection mirror 102 corresponds to the first doped layer 141.

More specifically, for example, the lower reflection mirror 102 may be configured of 35 laminated layer pairs each consisting of a laminated layer pair of an Al_{0.1}Ga_{0.9}As layer and an Al_{0.9}Ga_{0.1}As layer each layer having an optical film thickness of 1/4λc. Preferably, in a case where the uppermost layer of the lower reflection mirror 102 is an Al_{0.9}Ga_{0.1}As layer, this layer functions as the first doped layer 141.

As a result, the band diagram in Fig. 2 described above can be applied to the present embodiment. Thus, since the light emitting element 400 includes the first spacer layer 181 and the second spacer layer 182 also in the present embodiment, it is possible to reduce the consumption of carriers, and to prevent the peak values of the light pulses from becoming low. In other embodiments, the band gaps diagrams described in reference to other Figures may be applied to the present embodiment.

### [Fifth Embodiment]

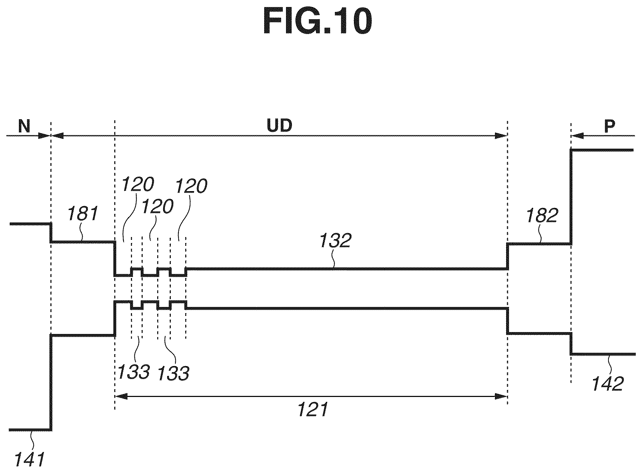

A fifth embodiment will be described with reference to Fig. 10. Fig. 10 is a modification example of the band diagram illustrating the vicinity of the active layer in Fig. 2.

Different from Fig. 2, Fig. 10 does not include the first barrier layer 131. In other words, the first spacer layer 181 and the quantum well layers 120 are provided adjacently.

As described in the first embodiment, in order to adjust the positions of the antinodes of the standing wave and the quantum well layers 120, the film thickness of the first barrier layer 131 and the film thickness of the second barrier layer 132 in Fig. 1 may be different. It is also possible to regard the example illustrated in Fig. 10 as an example of setting the film thickness of the first barrier layer 131 to 0.

In some embodiments, although not illustrated, in an opposite manner to illustrated embodiments, the film thickness of the second barrier layer 132 may be set to 0, that is to say that it is not included in a similar way to Fig. 5. In this case, the quantum well layers 120 and the second spacer layer 182 are arranged adjacently.

With the configuration described above, either one or both of the first spacer layer 181 and the second spacer layer 182 is provided, and thus it is possible to reduce the consumption of carriers and prevent the peak values of the light pulses from becoming low.

### [Sixth Embodiment]

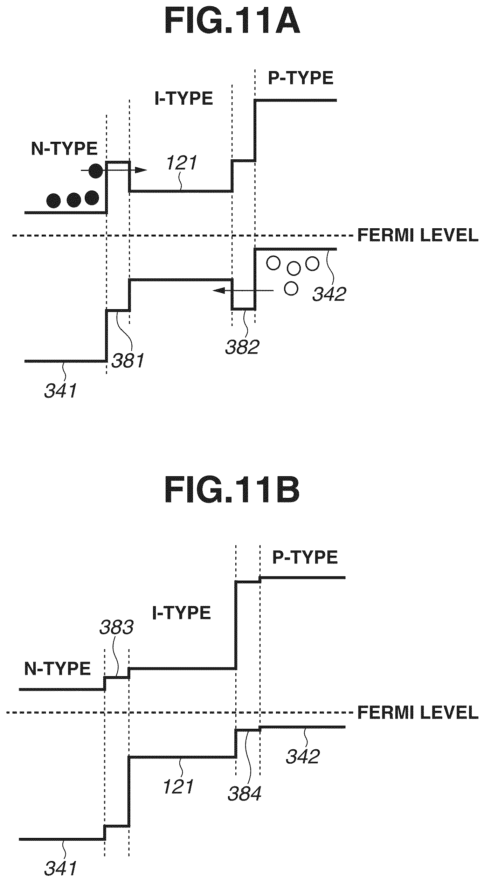

A sixth embodiment will be described with reference to Figs. 11A and 11B. In the present embodiment, a favorable range of the doping concentration in a case where the first spacer layer 181 or the second spacer layer 182 is to be provided will be considered.

Figs. 11A and 11B are band diagrams illustrating a vicinity of the active layer 121. Fig. 11A is the band diagram illustrating a first doped layer 341, a first spacer layer 381, the active layer 121 (quantum well layers are not illustrated), a second spacer layer 382, and a second doped layer 342.

The first doped layer 341 is an n-type semiconductor layer, and the doping concentration thereof is, for example, 1 × 10¹⁸ cm⁻³. The first spacer layer 381, the active layer 121, and the second spacer layer 382 are non-doped semiconductor layers. The second doped layer 342 is a p-type semiconductor layer, and the doping concentration thereof is, for example, 1 × 10¹⁸ cm⁻³.

In the case of the band diagram illustrated in Fig. 11A, the first spacer layer 381 functions as a potential barrier for electrons, and the second spacer layer 382 functions as a potential barrier for holes.

On the other hand, Fig. 11B illustrates an example in which the doping concentration of a first spacer layer 383 is set lower than that of the first doped layer 341, and the doping concentration of a second spacer layer 384 is set lower than that of the second doped layer 342.

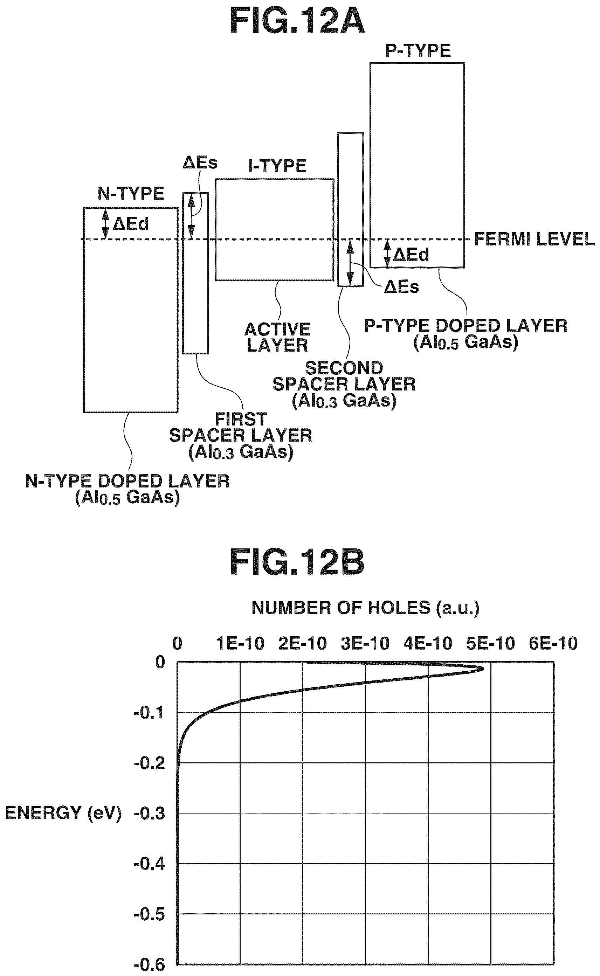

A range of the doping concentration of each of the spacer layers is considered with reference to Figs. 12A and 12B and other drawings. Fig. 12A is a schematic diagram illustrating a band gap of each of the semiconductor layers. Assume that the energy difference from the Fermi level to the upper end of the valence band is ΔEd for the p-type doped layer (Al_{0.5}Ga_{0.5}As) with a doping concentration of 1 × 10¹⁸ cm⁻³. Further, assume that the energy difference from the Fermi level to the upper end of the valence band is ΔEs for the second spacer layer (Al_{0.3}Ga_{0.7}As).

By the way, even if there is some potential barrier, holes can overcome the barrier. In other words, a part of carriers with high potentials for the holes can overcome the potential barrier, assuming the carrier distribution of the holes at about a room temperature.

Fig. 12B illustrates a distribution calculation result of holes of the p-type Al_{0.5}Ga_{0.5}As having a doping concentration of 1 × 10¹⁸ cm⁻³ in the energy direction. In Fig. 12B, the energy at the upper end of the valence band is set to 0.

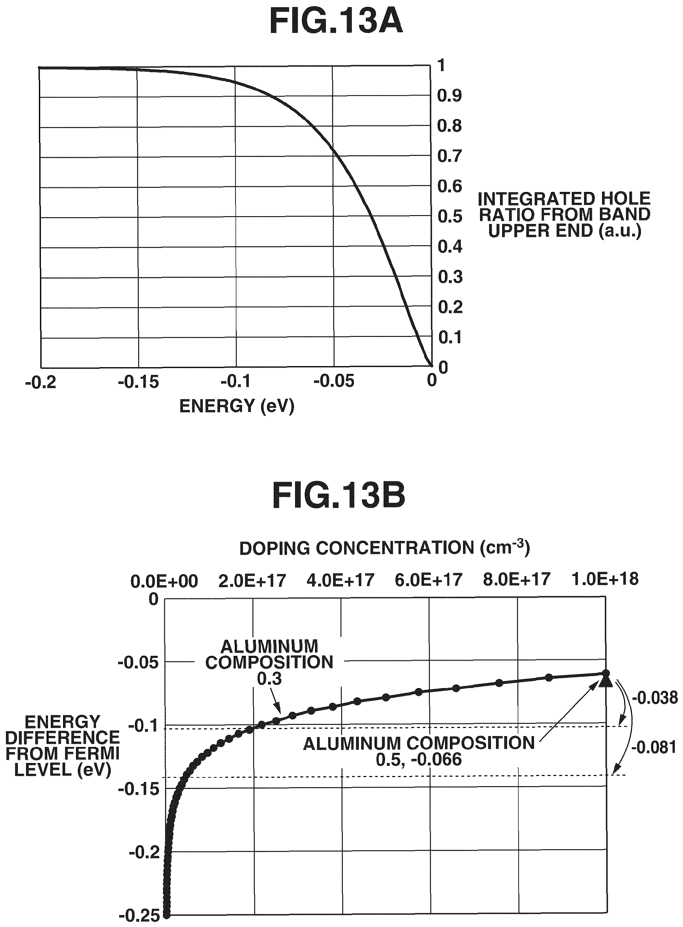

Fig. 13A is a graph illustrating a ratio of holes within a range from the upper end of the valence band to each energy position in the horizontal axis. From this graph, it can be seen that the ratio becomes 60% when the energy is -0.038 eV, and the ratio becomes 90% when the energy is -0.081 eV. In other words, 40% of holes can overcome the potential barrier with the energy of 0.038 eV, and 10% of holes can overcome the potential barrier with the energy of 0.081 eV. Thus, a doping concentration of the second spacer layer (Al_{0.3}Ga_{0.7}As) at which the difference between ΔEd and ΔEs becomes 0.038 eV or less or 0.081 eV or less is considered.

Fig. 13B is a graph illustrating a relationship between the energy difference (ΔEs) from the Fermi level to the upper end of the valence band, and the doping concentration of the second spacer layer. In Fig. 13B, since ΔEd of the p-type doped layer (Al_{0.5}Ga_{0.5}As) having a doping concentration of 1 × 10¹⁸ cm⁻³ is -0.066 eV, when -0.038 eV and -0.081 eV are respectively added to ΔEd, the energy differences become -0.104 eV and -0.147 eV. In this case, in the second spacer layer, the doping concentrations corresponding to the respective energy differences are 2.1 × 10¹⁷ cm⁻³ and 4.0 × 10¹⁶ cm⁻³. In this way, the doping concentration of the second spacer layer is desirably 4.0 × 10¹⁶ cm⁻³ or more, and is more desirably 2.1 × 10¹⁷ cm⁻³ or more.

On the other hand, the consumption of carriers due to the doping of the impurities is proportional to the doping concentration in the semiconductor layer. For example, in order to make the carrier consumption in the spacer layer about half of the carrier consumption in the p-type doped layer, the doping concentration may simply be set to 5.0 × 10¹⁷ cm⁻³, which is half of 1.0 × 10¹⁸ cm⁻³.

As described above, the doping concentration of the second spacer layer 384 is suitably set to 4.0 × 10¹⁶ cm⁻³ or more and 5.0 × 10¹⁷ cm⁻³ or less, and more suitably to 2.1 × 10¹⁷ cm⁻³ or more and 5.0 × 10¹⁷ cm⁻³ or less. That is to say that the doping concentration may be in the range of 4.0 × 10¹⁶ cm⁻³ to 5.0 × 10¹⁷ cm⁻³ or 2.1 × 10¹⁷ cm⁻³ to 5.0 × 10¹⁷ cm⁻³.

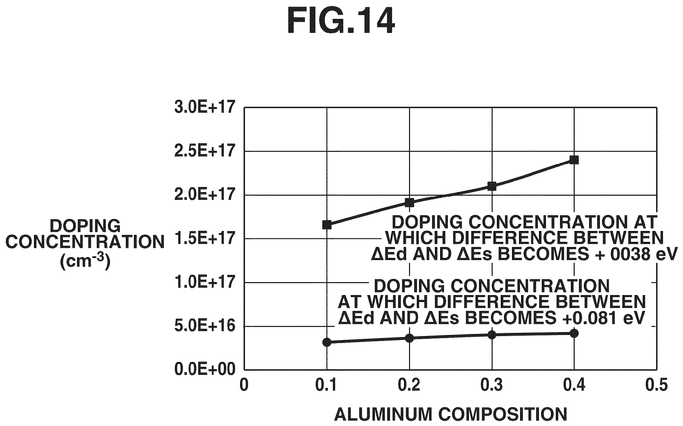

Fig. 14 is a graph illustrating an Al composition dependency of AlGaAs with a doping concentration at which the differences each between ΔEd and ΔEs become -0.038 eV and - 0.081 eV. In a case where the second spacer layer is made to be the Al composition illustrated in Fig. 14, the suitable lower limit value of the doping concentration can be read from Fig. 14.

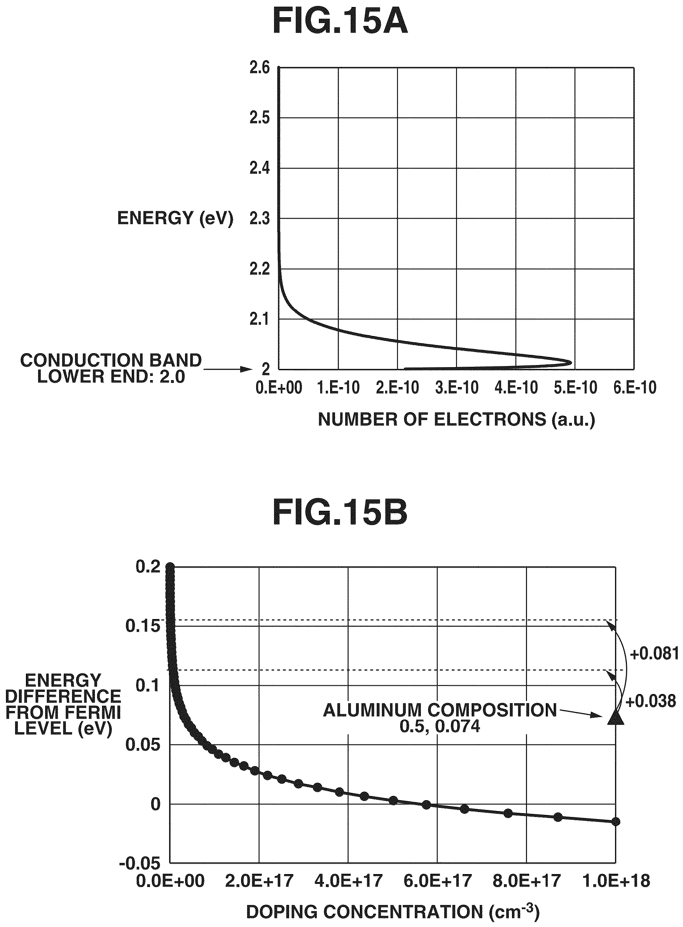

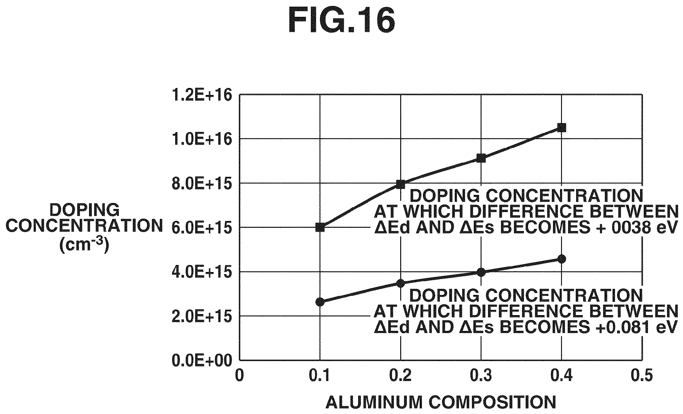

Similarly, in Figs. 15A, 15B, and 16, calculation results about n-type doped electrons are illustrated. Fig. 15A illustrates a distribution of electrons in a conduction band of n-type Al_{0.9}GaAs having a doping concentration of 1 × 10¹⁸ cm⁻³, in the energy direction. In Fig. 15A, the lower end of the conduction band is the energy 2.0 eV position. Thus, the ratio becomes 60% by integrating energy from the lower end of the conduction band at the energy + 0.038 eV from the lower end of the conduction band, and becomes 90% at the energy + 0.081 eV from the lower end of the conduction band.

Fig. 15B illustrates a relationship between the energy difference (ΔEs) from the Fermi level to the lower end of the conduction band, and the doping concentration of the first spacer layer (Al_{0.3}Ga_{0.7}As). In Fig. 15B, since ΔEd of the n-type doped layer (Al_{0.5}Ga_{0.5}As) having a doping concentration of 1 × 10¹⁸ cm⁻³ is +0.074 eV, when +0.038 eV and +0.081 eV are respectively added thereto, the energy differences become 0.112 eV and 0.155 eV. Then, the energy differences become ΔEs when the doping concentrations are respectively 9.1 × 10¹⁵ cm⁻³ and 4.0 × 10¹⁵ cm⁻³. The doping concentration of the first spacer layer 383 can be set to 4.0 × 10¹⁵ cm⁻³ or more and 5.0 × 10¹⁷ cm⁻³ or less, and more suitably to 9.1 × 10¹⁵ cm⁻³ or more and 5.0 × 10¹⁷ cm⁻³ or less.

Fig. 16 is a graph illustrating an Al composition dependency of AlGaAs of the doping concentrations at which the differences between ΔEd and ΔEs become 0.038 eV and 0.081 eV. From this graph, it is possible to read the lower limit value of the suitable doping concentration in a case where the Al composition of the spacer layer is changed using the present embodiment as a base.

As described above, by doping the first spacer layer 383 or the second spacer layer 382, the potential barrier for the majority carriers of the doped layer can be lowered, and the carriers can overcome the barrier also in a thermal equilibrium state. As a result, the potential difference applied for the majority carriers to overcome the barrier can be lowered. In other words, the carriers can be injected into the active layer with a lower voltage.

### [Seventh Embodiment]

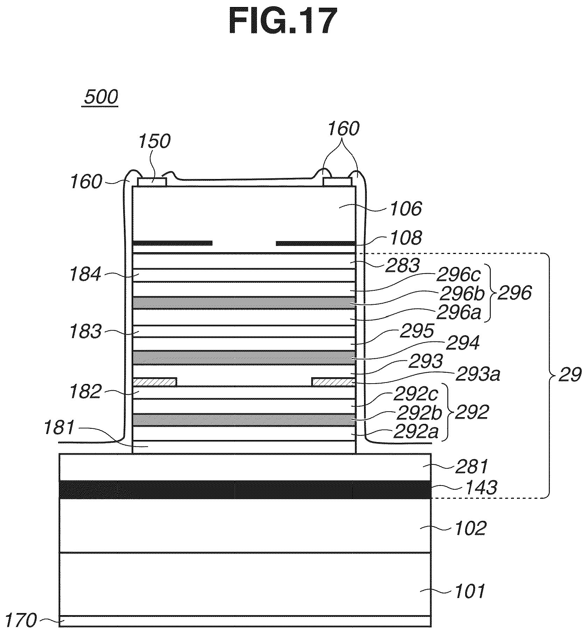

A seventh embodiment will be described with reference to Fig. 17. Fig. 17 is a cross-section diagram schematically illustrating a configuration of a light emitting element 500 according to the seventh embodiment. In the embodiments described above, a so-called single junction type resonator that has one p-i-n structure in the resonator is described, but the present embodiment is different from the embodiments described above in that the resonator is a multi-junction type resonator that has a plurality of p-i-n structures in the resonator. With reference to Fig. 17, an example of a so-called 2 junction type resonator having two p-i-n junctions in a resonator 29 will be described, but the junction type is not limited thereto. That is to say it may be referred to a multijunction type resonator, or similar, comprising a number of p-i-n junctions in the resonator.

In the present embodiment, configurations other than the resonator 29 may preferably be similar to those in the first embodiment.

Also in the present embodiment, the lower electrode 170 is provided on the back surface of the semiconductor substrate 101. The semiconductor substrate being provided on a lower side of the lower reflection mirror 102. The lower electrode being disposed to a back side of the light emitting element 500. A saturable absorption layer 143, preferably described in the first embodiment or other embodiments, is provided. A spacer portion may be provided above or below the saturable absorption layer 143, or spacer portions may be provided both above and below the saturable absorption layer 143. The spacer portion may be as described in the first embodiment or other embodiments.

In the present embodiment, the configuration of the resonator 29 provided on the lower reflection mirror 102 may be different to other embodiments. The resonator 29 includes, in order of proximity to the saturable absorption layer 143, an n-type layer 281, a first spacer layer 181, a non-doped spacer portion 292, a second spacer layer 182, a p-type layer 293, a tunnel junction layer 294, an n-type layer 295, a third spacer layer 183, a non-doped spacer portion 296, a fourth spacer layer 184, and a p-type layer 283. The layer of resonator 29 may be as described in reference to other embodiments, for example the first embodiment.

The n-type layers 281 and 295 may preferably be made of n-type AlGaAs.

Each of the non-doped spacer portions 292 and 296 may include quantum well layers. The p-type layers 293 and 283 are made of p-type AlGaAs. The non-doped spacer portions 292 and 296 respectively include one layer of active portion 292b and one layer of active portion 296b each including three quantum well layers at antinode positions of the standing wave.

Preferably, each of the active portions 292b and 296b can be configured of a multiple quantum well including three layers of the quantum wells each obtained by, for example, sandwiching an 8 nm thick InGaAs well layer between 10 nm GaAs barrier layers.

Other portions of spacers 292a and 296a, and 292c and 296c configuring the non-doped spacer portions 292 and 296 may be configured of non-doped GaAs layers.

Preferably, the first spacer layer 181 to the fourth spacer layer 184 are 30 nm thick Al_{0.9}GaAs layers. The first spacer layer 181 to the fourth spacer layer 184 are undoped layers or semiconductor layers each having a doping concentration lower than the doping concentrations of the n-type layers 281 and 295 or the p-type layers 293 and 283. With this configuration, the band gap difference between the barrier layer and the quantum well layer is 105 meV, and this configuration has an active layer configuration in which carriers are also accumulated in the above-described barriers.

The p-type layer 293 may include an oxide confinement layer 293a, which is a 30 nm-thick Al_{0.98}Ga_{0.02}As layer. The tunnel junction layer 294 can include a p-type layer and an n-type layer (not illustrated) highly doped to about 10¹⁹ cm⁻³ or more, to improve the tunnel probability. A highly doped p-type layer may be arranged on the side nearer to the p-type layer 293, and a highly doped n-type layer is arranged on the side farther from the p-type layer 293, i.e., on the side nearer to the n-type layer 291. With the above-described configuration, even if the current input to the light emitting element is the same, since the number of carriers generated in the resonator 29 becomes double compared with the single junction configuration, the light power can be increased.

In addition, in Fig. 17, the layers configuring the light emitting element 500 are illustrated as if the layers are in direct contact with each other, but another functional layer may be provided between arbitrary layers.

The example of a resonator with two junctions is described above, but the present disclosure is not limited thereto, and a resonator with three or more junctions can be employed based on the similar technical concept.

Further, in the present embodiment, the example of applying the multi-junction type resonator spacer portion to the first embodiment is described, but the multi-junction type resonator spacer portion can be applied to the second to sixth embodiments.

Further, also in a case where the oxide confinement layer 293a is not provided in the p-type layer 293, it is possible to increase the light power. Further, a different layer can be appropriately provided between layers, in addition to the configuration according to the present embodiment.

### [Eighth Embodiment]

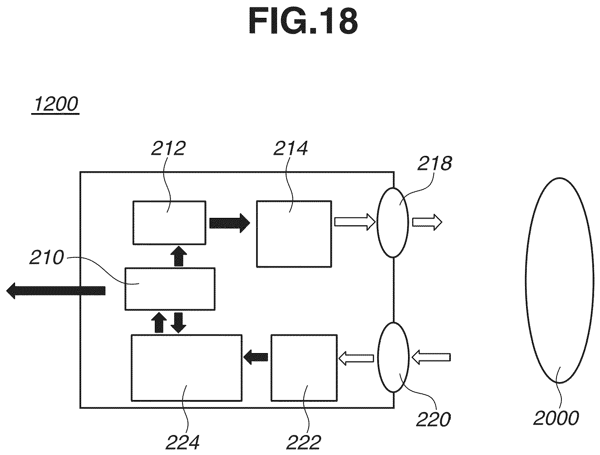

A distance measuring apparatus 1200 according to an eighth embodiment of the present disclosure will be described with reference to Fig. 18. Fig. 18 is a block diagram schematically illustrating the distance measuring apparatus 1200 according to the present embodiment.

The distance measuring apparatus 1200 according to the present embodiment is a distance measuring apparatus (preferably a light detection and ranging (LiDAR) apparatus) in which a surface emitting laser array with the light emitting elements according to the above-described embodiments arranged in a 2-dimensional manner is applied to a light source unit. That is to say the distance measuring apparatus may comprise a 2-dimensional array of light emitting elements according to any of the described embodiments.

The distance measuring apparatus 1200 according to the present embodiment includes a control unit 210, a surface emission laser array driver 212, a surface emission laser array 214, a light emission optical system 218, a light reception optical system 220, a sensor 222, and a distance data processing unit 224.

The surface emission laser array 214 is a unit which comprises a light emitting element, preferably a plurality of the light emitting elements, according to the above-described embodiments arranged and mounted in a package. The surface emission laser array driver 212 is a driving unit that receives a driving signal from the control unit 210, generates a driving current for oscillating the surface emission laser array 214, and outputs the driving current to the surface emission laser array 214. In addition, the surface emission laser array 214 and the surface emission laser array driver 212 may be integrally formed in one device.

The light emission optical system 218 is an optical system for emitting laser light generated by the surface emission laser array 214 to a distance measuring target range. The light reception optical system 220 is an optical system for guiding the laser light reflected from a measuring target object 2000 to the sensor 222. In addition, in Fig. 18, each of the light emission optical system 218 and the light reception optical system 220 is expressed by one convex lens shaped member. Preferably each of the light emission optical system 218 and the light reception optical system 220 may comprise a lens group including a plurality of lenses, not only one convex lens shaped member.

The sensor 222 is a photoelectric conversion device in which a plurality of pixels each including a photoelectric conversion unit is arranged in a 2-dimensional array manner. The sensor 22 comprises a light reception device that outputs an electrical signal corresponding to the input light. For example, the sensor 222 is a complementary metal-oxide semiconductor (CMOS) sensor or a single photon avalanche diode (SPAD) sensor. The distance data processing unit 224 has a function, as an information acquisition unit, of generating information about a distance to the measuring target object 2000 present in a distance measuring target range based on the time difference between a light emitting timing from the surface emission laser array 214 and a light receiving timing by the sensor 222 (e.g. based on the time-of-flight), and of outputting the generated information. The distance data processing unit 224 only needs to be electrically connected with the sensor 222, and may be arranged in the same package as the sensor 222, or may be arranged in a package different from the sensor 222.

The control unit 210 includes a microcomputer or an information processing apparatus including logical circuits. The control unit has a function as a main processing device for controlling operations of the distance measuring apparatus 1200, such as controlling operations of each unit and various kinds of calculation processing.

As described above, as a light emitting element suitable for the LiDAR system, a light emitting element that can generate light pulses with short light pulse widths and high peak values is desirable. More specifically, for example, the suitable light pulse widths of the light source for the LiDAR system are within a range between about 50 ps and 1 ns. On the other hand, from an electrical view point for the VCSEL and driving the VCSEL, it is not easy to cause the VCSEL to emit light in such short pulse widths. As the VCSEL emits light corresponding to the input current amount, to make the light pulse widths between about 50 ps and 1 ns, the electric pulses for driving the VCSEL need to have pulse widths almost the same as those. Thus, an electrical transmission portion from the driver unit to the VCSEL needs to have excellent electrical characteristics for a high frequency band such as 1 GHz and 10 GHz as frequency components, and needs to handle currents above 1 A. The configuration described above causes the costs thereof to be higher than the costs of a case where the electrical transmission portion from the driver unit to the VCSEL is configured only by electrical circuits for handling the frequency band lower than the high frequency band, which is an issue.

Thus, in the present embodiment, the VCSEL itself emits short pulses by using the light emitting element described according to the above-described embodiments. In this way, the light pulses with pulse widths from about 50 ps to 1 ns suitable for the LiDAR system are obtained while preventing the costs of the driver unit and the electrical transmission portion from being high.

First, the control unit 210 outputs a driving signal to the surface emission laser array driver 212. Upon receiving the driving signal from the control unit 210, the surface emission laser array driver 212 inputs current of a predetermined current value to the surface emission laser array 214. In this way, the surface emission laser array 214 starts oscillating, and laser light is emitted from the surface emission laser array 214. At this time, the pulse widths of the light emitted from the surface emission laser array 214 are narrower than the pulse widths of the input current as described above.

The laser light generated by the surface emission laser array 214 is emitted to the distance measuring target range through the light emission optical system 218. From the laser light emitted to the measuring target object 2000 present in the distance measuring target range, the laser light reflected by the measuring target object 2000 and input to the light reception optical system 220 is guided to the sensor 222 through the light reception optical system 220.

Each pixel of the sensor 222 generates an electrical signal pulse corresponding to an input timing of the laser light. The electrical signal pulse generated by the sensor 222 is input to the distance data processing unit 224.

The distance data processing unit 224 generates information about the distance to the measuring target object 2000 along the light propagation direction, based on the reception timing of the electrical signal pulse output from the sensor 222. By calculating the distance information based on the electrical signal pulse output from each pixel of the sensor 222, 3-dimensional information of the measuring target object 2000 can be obtained.

For example, in the automotive field, the distance measuring apparatus 1200 according to the present embodiment can be applied to a control device for controlling a vehicle so as not to collide with another vehicle, and a control device for controlling a vehicle to perform automatic driving following another vehicle. Further, the distance measuring apparatus 1200 according to the present embodiment can be applied to not only vehicles but also to other movable bodies (movable apparatuses), such as ships, airplanes, and industrial robots, and movable body detection systems. The distance measuring apparatus 1200 according to the present embodiment can be widely applied to apparatuses that use information, including the distance information, about 3-dimensionally recognized objects. These movable bodies can be configured to include the distance measuring apparatus 1200 according to the present embodiment, and a control unit for controlling the movable body based on the information about the distance obtained by the distance measuring apparatus 1200.

Further, the 3-dimensional information including depth information obtainable by the distance measuring apparatus 1200 according to the present embodiment is usable by image capturing apparatuses, image processing apparatuses, display apparatuses, and the like. For example, by using the 3-dimensional information acquired by the distance measuring apparatus 1200 according to the present embodiment, it is possible to display a virtual object on a real-world image without giving a feeling of strangeness. Further, by storing the 3-dimensional information together with the image information, it is also possible to correct the amount of blur of the captured image after the image is captured.

As described above, according to the present embodiment, it is possible to achieve a high performance distance measuring apparatus including light emitting elements that can generate light pulses with short light pulse widths and high peak values.

However, various modifications are possible without being limited to the above-described embodiments. An example in which a part of the configuration of any of the embodiments is added to another embodiment, or a part of the configuration is replaced with a part of the configuration of another embodiment is also one of the embodiments of the present disclosure. Further, in the present specification, a part of the items described in the comparative example can be added to or replaced in the plurality of embodiments described above.

Further, in the above-described embodiments, GaAs, AlGaAs, and InGaAs are exemplified as the semiconductor materials with which the crystal growth is possible in the case where the GaAs substrate is used as the semiconductor substrate 101, but the semiconductor substrate 101 is not limited to the GaAs substrate. For example, an indium phosphide (InP) substrate can be used as the semiconductor substrate 101. In the case where the InP substrate is used as the semiconductor substrate 101, examples of semiconductor materials with which the crystal growth is possible include InP, InGaAs, indium gallium phosphide (InGaP), and indium gallium arsenide phosphide (InGaAsP).

Further, the reflection mirror in the light emitting element according to the above-described embodiments does not necessarily need to be made of the semiconductor material, and may be made of another material other than the semiconductor material. For example, the reflection mirror may be a dielectric multilayer film.

All the above-described embodiments are merely specific examples for achieving the present disclosure, and the technical range of the present disclosure shall not be construed as being limited.

Thus, the present disclosure can be realized in diverse ways so long as it is in accordance with the technological thought or main features of the present disclosure.

The disclosure of the above-described embodiments includes the following configurations.

### (Configuration 1)

A light emitting element including:
a first reflection mirror provided on (or above or to one side of) a semiconductor substrate;
a second reflection mirror provided on (or above or to one side of) the first reflection mirror;
a resonator provided between the first reflection mirror and the second reflection mirror;
an active layer included in the resonator and including a quantum well layer and a barrier layer;
a doped layer provided on (or to) at least one of a side of the active layer facing the semiconductor substrate and a side opposite to the semiconductor substrate;
a spacer layer provided between the doped layer and the barrier layer and having a band gap larger than a band gap of the barrier layer; and
a saturable absorption layer provided between the semiconductor substrate and the second reflection mirror,
wherein a doping concentration of the spacer layer is lower than a doping concentration of the doped layer.

### (Configuration 2)

A light emitting element including:
a first reflection mirror provided on a semiconductor substrate;
a second reflection mirror provided on (or above or to one side of) the first reflection mirror;
a resonator provided between the first reflection mirror and the second reflection mirror;
an active layer included in the resonator and including a quantum well layer and a barrier layer;
a doped layer provided on (or to) at least one of a side of the active layer facing the semiconductor substrate and a side opposite to the semiconductor substrate; and
a spacer layer provided between the doped layer and the barrier layer and having a band gap larger than a band gap of the barrier layer,
wherein a doping concentration of the spacer layer is lower than a doping concentration of the doped layer, and
wherein the light emitting element is configured to emit light having a profile including a maximum peak value and converging to a stable value, which is a predetermined light intensity, after the maximum peak value.

### (Configuration 3)

The light emitting element according to Configuration 1 or 2,
wherein the doped layer includes a first doped layer provided on (or to) the side of the active layer facing the semiconductor substrate and a second doped layer provided on the side opposite to the semiconductor substrate,
wherein the barrier layer includes a first barrier layer provided on (or to) a side of the quantum well layer facing the semiconductor substrate and a second barrier layer provided on (or to) a side opposite to the semiconductor substrate, and
wherein the spacer layer includes a first spacer layer provided between the first doped layer and the first barrier layer and a second spacer layer provided between the second doped layer and the second barrier layer.

### (Configuration 4)

The light emitting element according to any one of Configurations 1 to 3, wherein at least one of the spacer layers is an undoped layer.

### (Configuration 5)

The light emitting element according to Configuration 3, wherein the second doped layer is a part of the second reflection mirror.

### (Configuration 6)

The light emitting element according to Configuration 3, wherein the first doped layer is a part of the first reflection mirror.

### (Configuration 7)

The light emitting element according to any one of Configurations 1 to 6, wherein a film thickness of the spacer layer is 5 nm or more and 100 nm or less.

### (Configuration 8)

The light emitting element according to any one of Configurations 1 to 7, wherein a film thickness of the spacer layer is 10 nm or more and 50 nm or less.

### (Configuration 9)

The light emitting element according to any one of Configurations 1 to 8, wherein a film thickness of the barrier layer is 50 nm or more.

### (Configuration 10)

The light emitting element according to any one of Configurations 1 to 9, wherein a ratio of a thickness of the barrier layer to a thickness of the spacer layer is 0.5 or more and 10 or less.

### (Configuration 11)

The light emitting element according to any one of Configurations 1 to 10, wherein a ratio of a thickness of the barrier layer to a thickness of the spacer layer is 1 or more and 5 or less.

### (Configuration 12)

The light emitting element according to Configuration 3, wherein a doping concentration of the first spacer layer is 4.0 × 10¹⁵ cm⁻³ or more and 5.0 × 10¹⁷ cm⁻³ or less.

### (Configuration 13)

The light emitting element according to Configuration 3, wherein a doping concentration of the second spacer layer is 4.0 × 10¹⁶ cm⁻³ or more and 5.0 × 10¹⁷ cm⁻³ or less.

### (Configuration 14)

The light emitting element according to any one of Configurations 1 to 13, wherein the light emitting element emits light having a profile including a maximum peak value and converging to a stable value, which is a predetermined light intensity, after the maximum peak value.

### (Configuration 15)

The light emitting element according to Configuration 1, wherein a relationship $Γs \times gmax \left(lop\right) > Γa \times α 2 + αm + αi$ is satisfied, where Γs is an optical confinement coefficient of the active layer, Γa is an optical confinement coefficient of the saturable absorption layer, gmax(lop) is a maximum gain of the active layer obtainable when an input current value is lop, α2 is an absorption coefficient of the saturable absorption layer, αm is a mirror loss, and αi is an optical absorption by carriers.

### (Configuration 16)

The light emitting element according to any one of Configurations 1 to 15,
wherein the quantum well layer is made of InGaAs, and
wherein the barrier layer is made of GaAs.

### (Configuration 17)

The light emitting element according to any one of Configurations 1 to 16,
wherein the active layer includes the quantum well layer and the barrier layer, and
wherein a band gap difference between the quantum well layer and the barrier layer in the active layer is 60 meV or more and 230 meV or less.

### (Configuration 18)

The light emitting element according to any one of Configurations 1 to 17,
wherein the active layer includes the quantum well layer and the barrier layer, and
wherein a band gap difference between the quantum well layer and the barrier layer in the active layer is 105 meV or more and 230 meV or less.

### (Configuration 19)

A distance measuring apparatus including:
the light emitting element according to any one of Configurations 1 to 18;
a light reception device configured to receive light emitted from the light emitting element and reflected from a measuring target object; and
a distance information acquisition unit configured to acquire information about a distance to the measuring target object, based on a time difference between a timing at which the light is emitted from the light emitting element and a timing at which the light reception device receives the light.

### (Configuration 20)

A movable body comprising:
the distance measuring apparatus according to Configuration 19; and
a control unit configured to control the movable body based on the information regarding the distance acquired by the distance measuring apparatus.

The term 'on' may man directly on or it may be indirectly on. In the case of directly on, e.g. a second layer on a first layer, one side of a first layer is adjacent to a side of a second layer. In the case of indirectly on, intermediary layers may be provided, e.g. a second layer one a first layer, the second layer may be spaced by an intermediary layer. Put another way, the term 'on' does not necessarily impart that the described layers are in direct contact. Put another way, one layer by be provided to another layer or provided to one side of another layer. It is also possible to consider that one layer may be provided above the other layer in a stack of layers when considering the light emitting element (i.e. stack of layers) being in a particular orientation.

According to the present disclosure, it is possible to provide a light emitting element improved over Japanese Patent Laid-open Publication No. 2022-176886 and a distance measuring device using such a light emitting element.

Various embodiments have been described in detail above but it will be understood that the present disclosure is not limited to these embodiments and encompasses all modifications, variants, alternatives and equivalents falling within the scope of the appended claims.

## Claims

1. A light emitting element (100, 200, 500) comprising:
a first reflection mirror (102) provided on a semiconductor substrate (101);
a second reflection mirror (106) provided on the first reflection mirror;
a resonator (103, 203, 29) provided between the first reflection mirror and the second reflection mirror;
an active layer (121, 292, 296) included in the resonator, the active layer comprising a quantum well layer (120) and a barrier layer (131, 132, 133);
a doped layer (141, 142) provided on at least one of a side of the active layer facing the semiconductor substrate and a side opposite to the semiconductor substrate;
a spacer layer (181, 182, 183, 184) provided between the doped layer and the barrier layer and having a band gap larger than a band gap of the barrier layer; and
a saturable absorption layer (143) provided between the semiconductor substrate and the second reflection mirror,
wherein a doping concentration of the spacer layer is lower than a doping concentration of the doped layer.

2. A light emitting element (100, 200, 300, 400, 500) comprising:
a first reflection mirror (102) provided on a semiconductor substrate (101);
a second reflection mirror (106) provided on the first reflection mirror;
a resonator (103, 203, 403, 29) provided between the first reflection mirror and the second reflection mirror;
an active layer (121, 292, 296) included in the resonator, the active layer comprising a quantum well layer (120) and a barrier layer (131, 132, 133);
a doped layer (141, 142) provided on at least one of a side of the active layer facing the semiconductor substrate and a side opposite to the semiconductor substrate; and
a spacer layer (181, 182, 183, 184) provided between the doped layer and the barrier layer and having a band gap larger than a band gap of the barrier layer,
wherein a doping concentration of the spacer layer is lower than a doping concentration of the doped layer, and
wherein the light emitting element is configured to emit light having a profile including a maximum peak value and converging to a stable value, which is a predetermined light intensity, after the maximum peak value.

3. The light emitting element according to claim 1 or 2,
wherein the doped layer includes a first doped layer (141) provided on the side of the active layer facing the semiconductor substrate (101) and a second doped layer (142) provided on the side opposite to the semiconductor substrate,
wherein the barrier layer includes a first barrier layer (131) provided on a side of the quantum well layer (120) facing the semiconductor substrate and a second barrier layer (132) provided on a side opposite to the semiconductor substrate, and
wherein the spacer layer includes a first spacer layer (181) provided between the first doped layer and the first barrier layer and a second spacer layer (182) provided between the second doped layer and the second barrier layer.

4. The light emitting element according to any one of claims 1 to 3, wherein at least one of the spacer layers (181, 182) is an undoped layer.

5. The light emitting element according to claim 3, wherein the second doped layer (142) is a part of the second reflection mirror (106).

6. The light emitting element according to claim 3, wherein the first doped layer (141) is a part of the first reflection mirror (102).

7. The light emitting element according to any one of claims 1 to 6, wherein a film thickness of the spacer layer is 5 nm or more and 100 nm or less.

8. The light emitting element according to any one of claims 1 to 7, wherein a film thickness of the spacer layer is 10 nm or more and 50 nm or less.

9. The light emitting element according to any one of claims 1 to 8, wherein a film thickness of the barrier layer is 50 nm or more.

10. The light emitting element according to any one of claims 1 to 9, wherein a ratio of a thickness of the barrier layer to a thickness of the spacer layer is 0.5 or more and 10 or less.

11. The light emitting element according to claim 1, wherein a ratio of a thickness of the barrier layer to a thickness of the spacer layer is 1 or more and 5 or less.

12. The light emitting element according to claim 3, wherein a doping concentration of the first spacer layer is 4.0 × 10¹⁵ cm⁻³ or more and 5.0 × 10¹⁷ cm⁻³ or less.

13. The light emitting element according to claim 3, wherein a doping concentration of the second spacer layer is 4.0 × 10¹⁶ cm⁻³ or more and 5.0×10¹⁷ cm⁻³ or less.

14. The light emitting element according to any one of claims 1 to 13, wherein the light emitting element is configured to emit light having a profile including a maximum peak value and converging to a stable value, which is a predetermined light intensity, after the maximum peak value.

15. The light emitting element according to claim 1 or any one of claims 3 to 14, when dependent upon claim 1, wherein a relationship $Γs \times gmax \left(lop\right) > Γa \times α 2 + αm + αi$ is satisfied, where Γs is an optical confinement coefficient of the active layer, Γa is an optical confinement coefficient of the saturable absorption layer, gmax(lop) is a maximum gain of the active layer obtainable when an input current value is lop, α2 is an absorption coefficient of the saturable absorption layer, αm is a mirror loss, and αi is an optical absorption by carriers.

16. The light emitting element according to any one of claims 1 to 15,
wherein the quantum well layer is made of InGaAs, and
wherein the barrier layer is made of GaAs.

17. The light emitting element according to any one of claims 1 to 16,
wherein a band gap difference between the quantum well layer and the barrier layer in the active layer is 60 meV or more and 230 meV or less.

18. The light emitting element according to any one of claims 1 to 17,
wherein a band gap difference between the quantum well layer and the barrier layer in the active layer is 105 meV or more and 230 meV or less.

19. A distance measuring apparatus (1200) comprising:
the light emitting element (100, 200, 300, 400, 500) according to any one of claims 1 to 18;
a light reception device (220) configured to receive light emitted from the light emitting element and reflected from a measuring target object; and
a distance information acquisition unit (224) configured to acquire information about a distance to the measuring target object, based on a time difference between a timing at which the light is emitted from the light emitting element and a timing at which the light reception device receives the light.

20. A movable body comprising:
the distance measuring apparatus (1200) according to claim 19; and
control means for controlling the movable body based on the information regarding the distance acquired by the distance measuring apparatus.
